# EUROPEAN PATENT APPLICATION

(11) **EP 4 773 793 A1**
(43) Date of publication of application: **08.07.2026**
(21) Application number: 25224279.7
(22) Date of filing: 17.12.2025
(51) Int. Cl.: H10P 72/00, H10P 72/76

(54) **SPIN-SPRAY COATING SYSTEM**

(30) Priority: 20.12.2024 US 202463737348 P
(71) Applicant: Scientech Corporation, Tapei City 11491 (TW)
(72) Inventor: CHENG, Yen-Hsiang, 11491 Taipei City (TW); TSAI, Wen-Ping, 11491 Taipei City (TW)
(74) Representative: Hautier IP - MC/EP

(57) **Abstract**

A spin-spray coating system adapted for coating a wafer (8) includes a base unit (10) and a top unit (20). The base unit (10) includes a base body (11) extending around a central axis (A) that extends vertically. The base body (11) has a top surface (110), an annular groove (113) recessed from the top surface (110), and extending around the central axis (A), and an outer cup support section (112) formed on the top surface (110), and extending around the central axis (A). The top unit (20) is removably mounted on the base unit (10), and includes a seat member (21) extending around the central axis (A), and removably inserted into the annular groove (113), and an outer cup member (24) extending around the central axis (A), disposed above the seat member (21), and removably engaging with the outer cup support section (112).

## Description

The disclosure relates to a coating system, and more particularly to a spin-spray coating system used for coating a wafer.

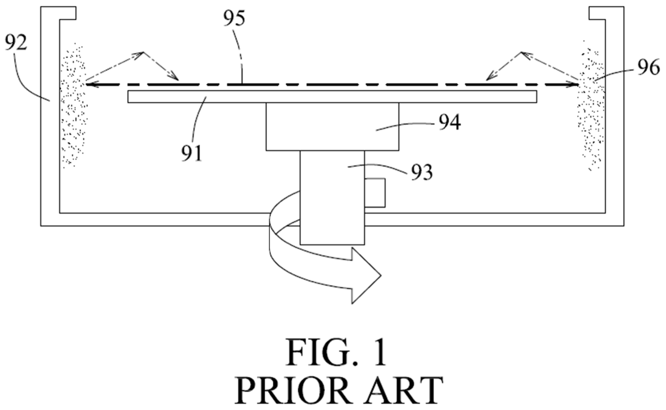

Referring to FIG. 1, a conventional spin coating system used for coating a semiconductor wafer 91 generally includes a bowl 92, a spin shaft 93 extending rotatably into the bowl 92, a chuck 94 co-rotatably connected to a top end of the spin shaft 93 and configured for holding the wafer 91, and a dispenser (not shown) provided for dispensing a coating material 95 on the wafer 91.

In a spin coating process, the dispenser dispenses the coating material 95 onto a top surface of the wafer 91 as the wafer 91 rotates with the chuck 94 and the spin shaft 93. The rotation of the wafer 91 causes the coating material 95 to distribute over the top surface thereof to form a thin coating layer, and any excess coating material 95 spun off from the top surface of the wafer 91 is splashed onto an inner wall of the bowl 92. Over time, the excess coating material 95 accumulates on the inner wall of the bowl 92 and produces a thick layer of material build-up 96.

A problem existing with the conventional spin coating system is that the material build-up 96 on the inner wall of the bowl 92 often causes the excess coating material 95 in subsequent coating processes to bounce back onto the top surface of the wafer 91, compromising the formation of the coating layer and thereby resulting in lower production yield. Another problem is that the material build-up 96 requires downtime as well as dismantling of the spin coating system for cleaning and maintenance of the bowl 92 and the chuck 94, all of which can greatly affect the utilization rate and the overall production cost of the system.

Therefore, an object of the disclosure is to provide a spin-spray coating system that can alleviate at least one of the drawbacks of the prior art.

According to an aspect of the disclosure, there is provided a spin-spray coating system according to claim 1.

Other features and advantages of the disclosure will become apparent in the following detailed description of the embodiment(s) with reference to the accompanying drawings. It is noted that various features may not be drawn to scale.
FIG. 1 is a schematic diagram of a conventional spin coating system.
FIG. 2 is a partially cross-sectional view, illustrating an embodiment of a spin-spray coating system according to the disclosure in use with a wafer.
FIG. 3 is a fragmentary and partially exploded cross-sectional view of the embodiment, illustrating a top unit being separated from a base unit.
FIG. 4 is a fragmentary perspective view of the embodiment, illustrating the top unit being disposed on the base unit.
FIG. 5 is a fragmentary, partially exploded and perspective cross-sectional view of the embodiment, illustrating structural details of the base unit and the top unit.
FIG. 6 is a fragmentary, exploded and perspective cross-sectional view of the embodiment, illustrating an outer cup member, an inner cup member, a ring member and a seat member of the top unit being separated from the base unit.
FIG. 7 is a fragmentary cross-sectional view of the embodiment, illustrating a trajectory of an excess of a coating material in the embodiment and an exit path of the excess out of the embodiment.
FIG. 8 is another fragmentary cross-sectional view of the embodiment, illustrating a flow path of air in the embodiment.

Before the disclosure is described in greater detail, it should be noted that where considered appropriate, reference numerals or terminal portions of reference numerals have been repeated among the figures to indicate corresponding or analogous elements, which may optionally have similar characteristics.

It should be noted herein that for clarity of description, spatially relative terms such as "top," "bottom," "upper," "lower," "on," "above," "over," "downwardly," "upwardly" and the like may be used throughout the disclosure while making reference to the features as illustrated in the drawings. The features may be oriented differently (e.g., rotated 90 degrees or at other orientations) and the spatially relative terms used herein may be interpreted accordingly.

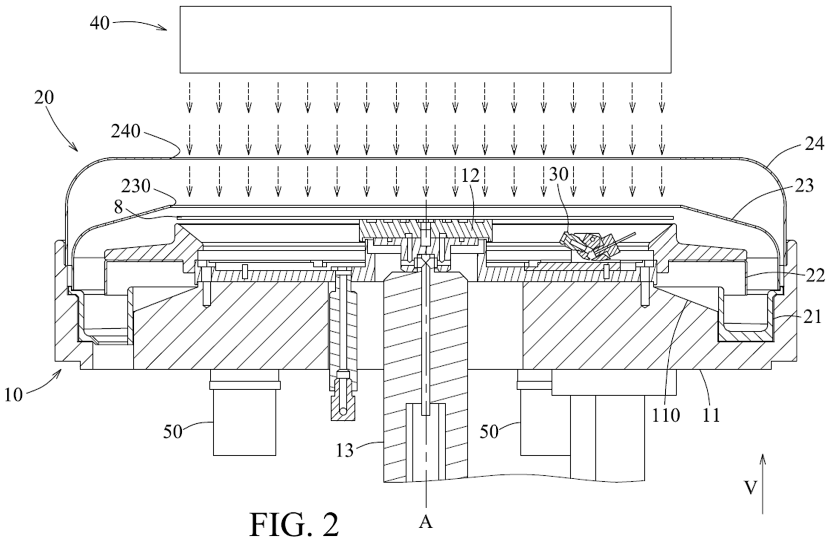

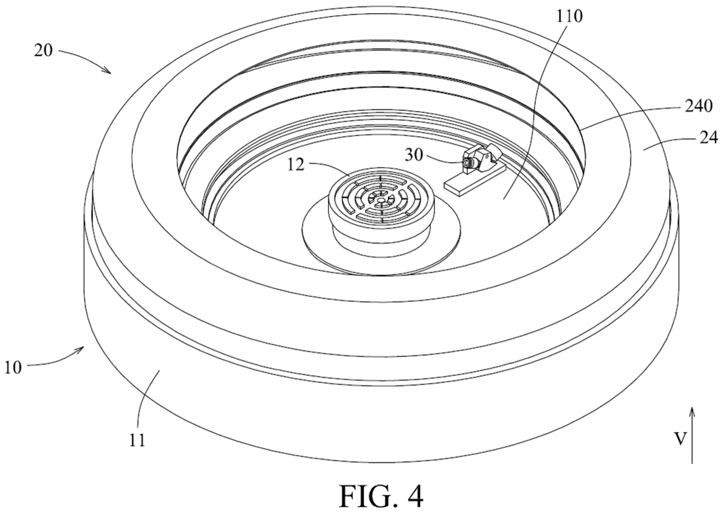

Referring to FIGS. 2 to 4, an embodiment of a spin-spray coating system according to the disclosure is adapted for coating a wafer 8. The spin-spray coating system includes a base unit 10, a top unit 20, a spray nozzle 30, a fan filter unit 40 and two exhaust pipes 50.

The base unit 10 includes a base body 11 that extends around a central axis (A) extending in a vertical direction (V), a chuck 12 that is disposed on the base body 11 along the central axis (A), and that is adapted for the wafer 8 to be disposed thereon, and a spin shaft 13 that extends rotatably through the base body 11 along the central axis (A), that is co-rotatably connected to the chuck 12, and that is adapted to drive the chuck 12 and the wafer 8 to co-rotate therewith about the central axis (A) relative to the base body 11.

The base body 11 has a top surface 110, a ring member support section 111 that is formed on the top surface 110 and that extends around the central axis (A), an outer cup support section 112 that is formed on the top surface 110, that extends around the central axis (A), and that surrounds and is spaced apart from the ring member support section 111, and an annular groove 113 that is recessed from the top surface 110, that extends around the central axis (A), and that is disposed between the ring member support section 111 and the outer cup support section 112.

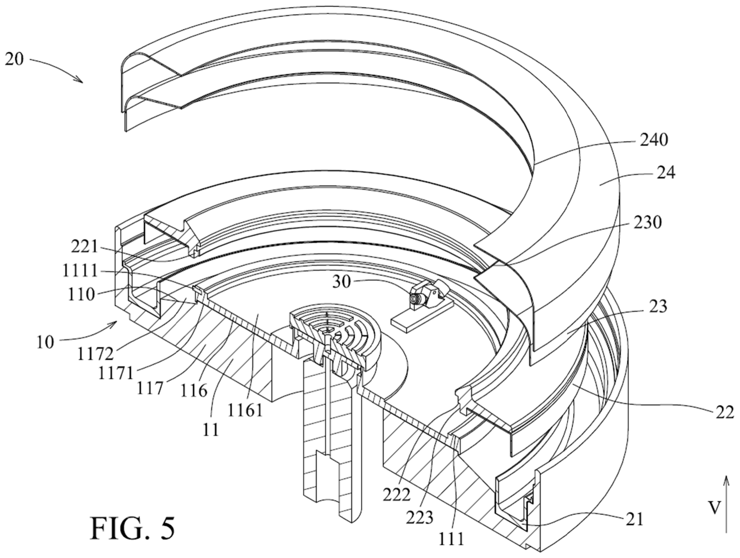

Referring to FIG. 5, specifically to the structure of the base body 11, the base body 11 includes a top flat portion 116, and a frusto-conical bottom portion 117 that is disposed under and connected to the top flat portion 116. The frusto-conical bottom portion 117 has an upper surface 1171 that is in contact with the top flat portion 116, and an inclined surrounding surface 1172 that extends downward from the upper surface 1171. The top flat portion 116 has a top face 1161 that is opposite to the frusto-conical bottom portion 117, and that cooperates with the inclined surrounding surface 1172 of the frusto-conical bottom portion 117 to form the top surface 110 of the base body 11.

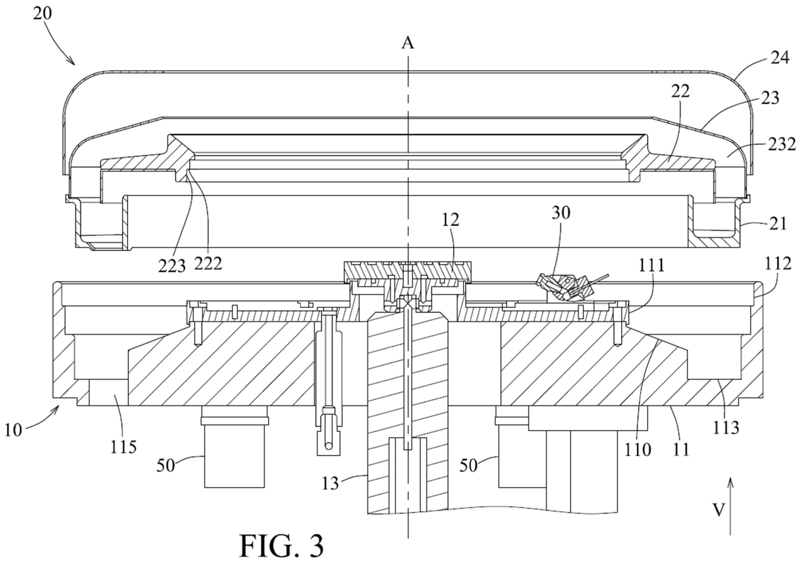

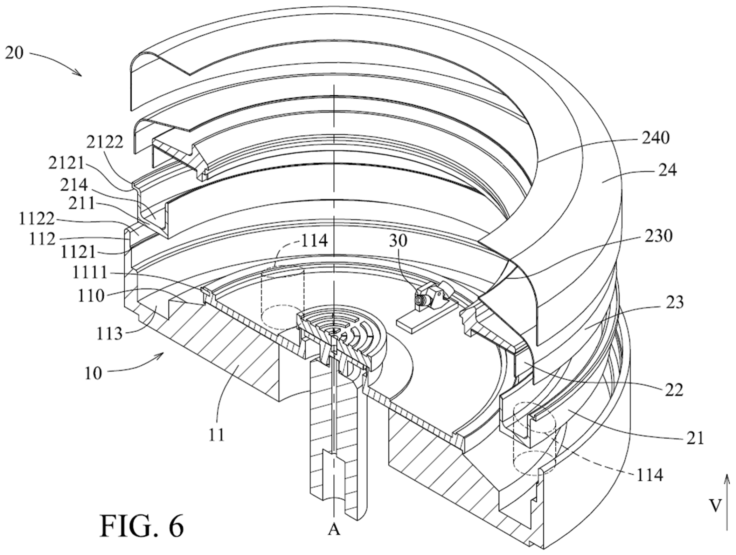

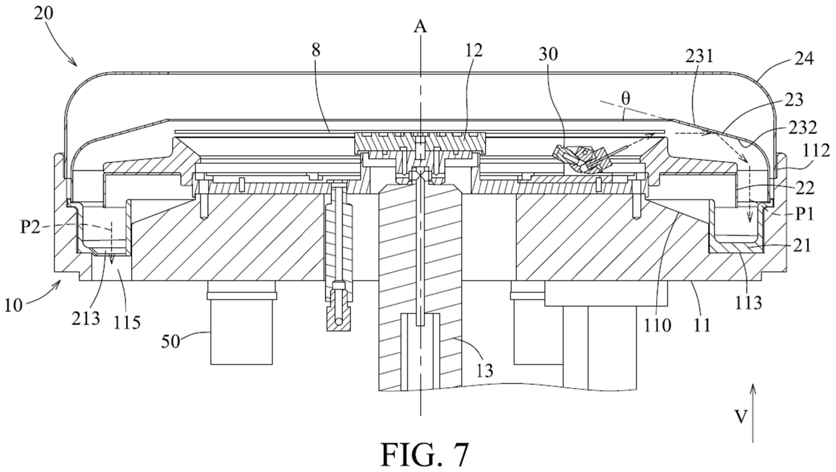

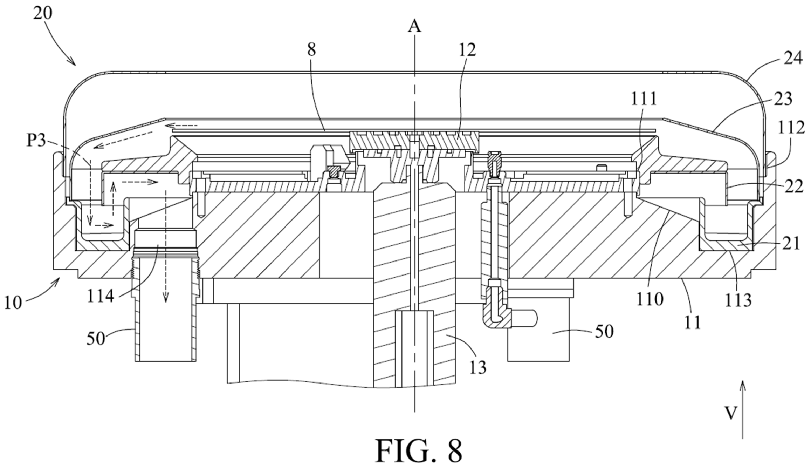

Moreover, the base body 11 of the base unit 10 is formed with two exhaust holes 114 (see FIGS. 6 and 8) that extend through the base body 11 in the vertical direction (V), and a lower drain hole 115 (see FIGS. 3 and 7) that extends through the base body 11 in the vertical direction (V), and that is disposed under the annular groove 113.

Referring to FIGS. 5 to 8, the top unit 20 is removably mounted on the base unit 10 along the central axis (A), and includes a seat member 21, a ring member 22, an inner cup member 23 and an outer cup member 24 that are separable from each other. The seat member 21 extends around the central axis (A), and is removably inserted into the annular groove 113 of the base body 11. The ring member 22 extends around the central axis (A), is disposed above the seat member 21, and removably engages with the ring member support section 111 of the base body 11. The inner cup member 23 extends around the central axis (A), is disposed above the ring member 22, and removably engages with the seat member 21. The outer cup member 24 extends around the central axis (A), is disposed above the inner cup member 23, and removably engages with the outer cup support section 112 of the base body 11.

Specifically, the seat member 21 has a bottom portion 211 that is received in the annular groove 113 of the base body 11, that has a U-shaped cross section, and that defines an annular seat groove 214 surrounding the central axis (A). The bottom portion 211 of the seat member 21 is formed with an upper drain hole 213 that is disposed above and aligned with the lower drain hole 115 of the base body 11. The lower drain hole 115 spatially interconnects the upper drain hole 213 and an external space.

The inner cup member 23 has an inclined portion 231 that is disposed around the central axis (A), and that extends inclinedly relative to the central axis (A). An angle (θ) (see FIG. 7) formed between a vertical cross section of the inclined portion 231 and an imaginary horizontal plane perpendicular to the central axis (A) ranges from 10 to 30 degrees. The inner cup member 23 further has an anti-adhesive layer 232 that is coated on an inner surface of the inner cup member 23 and that is made of an anti-adhesive material.

The outer cup member 24 surrounds and defines an outer cup opening 240. The inner cup member 23 surrounds and defines an inner cup opening 230 that is disposed under and spatially connected to the outer cup opening 240. The outer cup opening 240 and the inner cup opening 230 are adapted to expose the wafer 8 to an external space.

Referring specifically to FIG. 5 with regard to the engaging structures of the ring member 22 and the ring member support section 111 of the base body 11, the ring member 22 has a ring thread surface 222 that extends horizontally, that surrounds the central axis (A), and that abuts against a top end of the ring member support section 111, and a ring riser surface 223 that extends downward from an outer periphery of the ring thread surface 222, and that surrounds and abuts against a lateral side of the ring member support section 111. The ring thread surface 222 and the ring riser surface 223 cooperatively form an annular surface that has an inverted L-shaped profile, and that prevents horizontal translational movement of the ring member 22 relative to the base body 11. Furthermore, the ring member support section 111 of the base body 11 is a rim structure that protrudes upward, and the base body 11 further has a positioning pin 1111 that protrudes from a side of the rim structure and that protrudes radially away from the central axis (A). The ring member 22 is formed with a positioning cut 221 that is recessed from a bottom end of the ring member 22, and that engages with the positioning pin 1111 such that rotational movement of the ring member 22 relative to the base body 11 is also prevented.

Referring specifically to FIG. 6 with regard to the engaging structures of the inner cup member 23 and the seat member 21, the seat member 21 further has a seat thread portion 2121 that extends outward from an outer periphery of the bottom portion 211 toward the outer cup support section 112 of the base body 11, and that abuts against a bottom end of the inner cup member 23, and a seat riser portion 2122 that extends upward from an outer periphery of the seat thread portion 2121, and that surrounds and abuts against a lateral side of the inner cup member 23. The seat thread portion 2121 and the seat riser portion 2122 cooperatively form an annular structure that has an L-shaped cross section, and that prevents horizontal translational movement of the inner cup member 23 relative to the seat member 21.

Referring still to FIG. 6 with regard to the engaging structures of the outer cup member 24 and the outer cup support section 112 of the base body 11, the outer cup support section 112 of the base body 11 has an outer thread surface 1121 that extends horizontally, that surrounds the central axis (A), and that abuts against a bottom end of the outer cup member 24, and an outer riser surface 1122 that extends upward from an outer periphery of the outer thread surface 1121, and that surrounds and abuts against a lateral side of the outer cup member 24. The outer thread surface 1121 and the outer riser surface 1122 cooperatively form an annular surface that has an L-shaped profile, and that prevents horizontal translational movement of the outer cup member 24 relative to the base body 11.

Referring back to FIG. 2, the spray nozzle 30 is mounted on the base body 11 of the base unit 10, and is adapted for spraying a coating material, such as, but not limited to, polymers (e.g., PMMA, block copolymers), sol-gel precursors (e.g., silica, alumina), and photoresists, on a bottom surface of the wafer 8. The fan filter unit 40 is disposed above the top unit 20 and is adapted to push air through the outer cup opening 240 and inner cup opening 230 onto the wafer 8.

Referring to FIGS. 7 and 8, the two exhaust pipes 50 are connected to the base body 11 of the base unit 10 and are disposed proximate to the annular groove 113. Specifically, each of the exhaust holes 114 of the base body 11 is spatially connected to an open end of a respective one of the exhaust pipes 50, and is adapted to guide the air pushed through the outer cup opening 240 and the inner cup opening 230 into the respective one of the exhaust pipes 50.

During a coating process of the present embodiment, the spray nozzle 30 sprays the coating material on the bottom surface of the wafer 8 as the wafer 8 rotates with the chuck 12 and the spin shaft 13 and the fan filter unit 40 pushes air toward the top unit 20. The rotation of the wafer 8 distributes the coating material over the bottom surface of the wafer 8, and an excess of the coating material is spun off from the bottom surface of the wafer 8, impacts the anti-adhesive layer 232 on the inclined portion 231 of the inner cup member 23, and is deflected into a space defined between the seat member 21, the ring member 22 and the inner cup member 23. A trajectory (P1) of the excess of the coating material is illustrated in FIG. 7. It should be noted that by virtue of the angled design of the inclined portion 231 of the inner cup member 23 (i.e., the angle (θ) ranging from 10 to 30 degrees), the excess of the coating material impacting the inclined portion 231 of the inner cup member 23 is prevented from being deflected back to the wafer 8 and contaminating the bottom or top surface of the wafer 8. Furthermore, by virtue of the incorporation of the anti-adhesive layer 232, the excess of the coating material is prevented from accumulating on the inner surface of the inner cup member 23.

Once the excess of the coating material settles down, it is collected in the annular seat groove 214 of the seat member 21 and later drained out of the base body 11 through the upper and lower drain holes 213, 115 to be reclaimed or disposed of. An exit path (P2) of the excess of the coating material is illustrated in FIG. 7.

Meanwhile, the air pushed out by the fan filter unit 40 flows through the outer and inner cup openings 240, 230 and across the wafer 8, then enters the space defined between the seat member 21, the ring member 22 and the inner cup member 23, and is finally drawn into the exhaust pipes 50 through the exhaust holes 114 of the base body 11. A flow path (P3) of the air is illustrated in FIG. 8. During this process, the flow of air removes airborne particles, such as dust or droplets of the coating material, that could otherwise settle on the wafer 8 during the coating process, ensuring the required uniformity and resolution of coating results.

For cleaning and maintenance of the present embodiment, the top unit 20 is removed from the base unit 10 by simply lifting each member of the top unit 20, without a need of dismantling the base unit 10 or other components (i.e., the spray nozzle 30, the fan filter unit 40 and the exhaust pipes 50) of the embodiment. Specifically, to remove the top unit 20 from the base unit 10, the outer cup member 24, the inner cup member 23, the ring member 22 and the seat member 21 are lifted, in the order listed, from the outer cup support section 112 of the base body 11, the seat member 21, the ring member support section 111 of the base body 11 and the annular groove 113 of the base body 11, respectively. Since no fasteners are used for the engagement between each member of the top unit 20 and the base unit 10, the aforementioned process does not require a use of power tools or hand tools.

In summary, by virtue of the design of the inclined portion 231 of the inner cup member 23, the present embodiment is capable of preventing contamination of the wafer 8 during the coating process, and thereby produces a high production yield.

Moreover, by virtue of the incorporation of the anti-adhesive layer 232 of the inner cup member 23, the present embodiment is capable of preventing formation of a material build-up on the inner surface of the inner cup member 23 as well as preventing the excess of the coating material from being deflected back to the wafer 8 by the material build-up, and therefore requires relatively less cleaning and maintenance while ensuring a high production yield.

Finally, by virtue of the configurations of the base unit 10 and the top unit 20, each of the seat member 21, the ring member 22, the inner cup member 23 and the outer cup member 24 can be easily and quickly removed or replaced for cleaning and maintenance. Therefore, compared with the prior art, the present embodiment requires less downtime for cleaning and maintenance, thus providing an overall more efficient and cost-effective coating production.

In the description above, for the purposes of explanation, numerous specific details have been set forth in order to provide a thorough understanding of the embodiment(s). It will be apparent, however, to one skilled in the art, that one or more other embodiments may be practiced without some of these specific details. It should also be appreciated that reference throughout this specification to "one embodiment," "an embodiment," an embodiment with an indication of an ordinal number and so forth means that a particular feature, structure, or characteristic may be included in the practice of the disclosure. It should be further appreciated that in the description, various features are sometimes grouped together in a single embodiment, figure, or description thereof for the purpose of streamlining the disclosure and aiding in the understanding of various inventive aspects; such does not mean that every one of these features needs to be practiced with the presence of all the other features. In other words, in any described embodiment, when implementation of one or more features or specific details does not affect implementation of another one or more features or specific details, said one or more features may be singled out and practiced alone without said another one or more features or specific details. It should be further noted that one or more features or specific details from one embodiment may be practiced together with one or more features or specific details from another embodiment, where appropriate, in the practice of the disclosure.

## Claims

1. A spin-spray coating system adapted for coating a wafer (8), and including:
a base unit (10) including a base body (11) that extends around a central axis (A) which extends in a vertical direction (V), and a chuck (12) that is disposed on said base body (11) along the central axis (A), and that is adapted for the wafer (8) to be disposed thereon; and
a top unit (20) removably mounted on said base unit (10) along the central axis (A);
**characterized in that**:
said base body (11) has
a top surface (110),
an annular groove (113) that is recessed from said top surface (110), and that extends around the central axis (A), and
an outer cup support section (112) that is formed on said top surface (110), and that extends around the central axis (A); and
said top unit (20) includes
a seat member (21) that extends around the central axis (A), and that is removably inserted into said annular groove (113) of said base body (11), and
an outer cup member (24) that extends around the central axis (A), that is disposed above said seat member (21), and that removably engages with said outer cup support section (112) of said base body (11).

2. The spin-spray coating system as claimed in claim 1, wherein:
said base body (11) of said base unit (10) further has a ring member support section (111) that is formed on said top surface (110), and that extends around the central axis (A), said outer cup support section (112) surrounding and being spaced apart from said ring member support section (111), said annular groove (113) being disposed between said ring member support section (111) and said outer cup support section (112);
said top unit (20) further includes
a ring member (22) that extends around the central axis (A), that is disposed above said seat member (21), and that removably engages with said ring member support section (111) of said base body (11), and
an inner cup member (23) that extends around the central axis (A), that is disposed above said ring member (22), and that removably engages with said seat member (21); and
said outer cup member (24) is disposed above said inner cup member (23).

3. The spin-spray coating system as claimed in claim 2, wherein:
said ring member (22) is formed with a positioning cut (221) that is recessed from a bottom end of said ring member (22); and
said base body (11) further has a positioning pin (1111) that protrudes from a side of said ring member support section (111), that protrudes radially away from the central axis (A), and that engages with said positioning cut (221) of said ring member (22) such that rotational movement of said ring member (22) relative to said base body (11) is prevented.

4. The spin-spray coating system as claimed in any one of claims 2 and 3, wherein said inner cup member (23) has an inclined portion (231) disposed around the central axis (A) and extending inclinedly, an angle (θ) formed between a vertical cross section of said inclined portion (231) and an imaginary horizontal plane perpendicular to the central axis (A) ranging from 10 to 30 degrees.

5. The spin-spray coating system as claimed in any one of claims 2 to 4, wherein said inner cup member (23) has an anti-adhesive layer (232) coated on an inner surface of said inner cup member (23) and made of an anti-adhesive material.

6. The spin-spray coating system as claimed in any one of claims 2 to 5, wherein:
said outer cup member (24) surrounds and defines an outer cup opening (240): and
said inner cup member (23) surrounds and defines an inner cup opening (230) that is disposed under and spatially connected to said outer cup opening (240), said outer cup opening (240) and said inner cup opening (230) being adapted to expose the wafer (8) to an external space.

7. The spin-spray coating system as claimed in claim 6, wherein said spin-spray coating system further comprises at least one exhaust pipe (50) that is connected to said base body (11) of said base unit (10), and that is disposed proximate to said annular groove (113).

8. The spin-spray coating system as claimed in claim 7, wherein:
said base body (11) of said base unit (10) is formed with
at least one exhaust hole (114) that extends through said base body (11), that is spatially connected to an open end of said at least one exhaust pipe (50), and that is adapted to guide the air pushed through said outer cup opening (240) and said inner cup opening (230) into said at least one exhaust pipe (50), and
a lower drain hole (115) that extends through said base body (11), and that is disposed under said annular groove (113); and
said seat member (21) of said top unit (20) is formed with an upper drain hole (213) that is disposed above and aligned with said lower drain hole (115) of said base body (11), said lower drain hole (115) being adapted to spatially interconnect said upper drain hole (213) and an external space.

9. The spin-spray coating system as claimed in any one of claims 2 to 8, wherein said seat member (21) of said top unit (20) has:
a bottom portion (211) that is received in said annular groove (113) of said base body (11), that has a U-shaped cross section, and that defines an annular seat groove (214) surrounding the central axis (A);
a seat thread portion (2121) that extends outward from a periphery of said bottom portion (211) toward said outer cup support section (112) of said base body (11), and that abuts against a bottom end of said inner cup member (23); and
a seat riser portion (2122) that extends upward from a periphery of said seat thread portion (2121), and that surrounds and abuts against said inner cup member (23), said seat thread portion (2121) and said seat riser portion (2122) cooperatively forming an annular structure that has an L-shaped cross section, and that prevents horizontal translational movement of said inner cup member (23) relative to said seat member (21).

10. The spin-spray coating system as claimed in any one of claims 2 to 9, wherein:
said ring member support section (111) of said base body (11) is a rim structure that protrudes upward; and
said ring member (22) has
a ring thread surface (222) that extends horizontally, that surrounds the central axis (A), and that abuts against a top end of said ring member support section (111), and
a ring riser surface (223) that extends downward from a periphery of said ring thread surface (222), and that surrounds and abuts against said ring member support section (111), said ring thread surface (222) and said ring riser surface (223) cooperatively forming an annular surface that has an inverted L-shaped profile, and that prevents horizontal translational movement of said ring member (22) relative to said base body (11).

11. The spin-spray coating system as claimed in any one of claims 1 to 10, wherein said outer cup support section (112) of said base body (11) has:
an outer thread surface (1121) that extends horizontally, that surrounds the central axis (A), and that abuts against a bottom end of said outer cup member (24); and
an outer riser surface (1122) that extends upward from a periphery of said outer thread surface (1121), and that surrounds and abuts against said outer cup member (24), said outer thread surface (1121) and said outer riser surface (1122) cooperatively forming an annular surface that has an L-shaped profile, and that prevents horizontal translational movement of said outer cup member (24) relative to said base body (11).

12. The spin-spray coating system as claimed in any one of claims 1 to 11, wherein:
said base body (11) includes a top flat portion (116) and a frusto-conical bottom portion (117) that is disposed under and connected to said top flat portion (116);
said frusto-conical bottom portion (117) has an upper surface (1171) that is in contact with said top flat portion (116), and an inclined surrounding surface (1172) that extends downward from said upper surface (1171); and
said top flat portion (116) has a top face (1161) that is opposite to said frusto-conical bottom portion (117), and that cooperates with said inclined surrounding surface (1172) of said frusto-conical bottom portion (117) to form said top surface (110) of said base body (11).

13. The spin-spray coating system as claimed in any one of claims 1 to 12, wherein said base unit (10) further includes a spin shaft (13) extending rotatably through said base body (11) along the central axis (A), co-rotatably connected to said chuck (12), and adapted to drive said chuck (12) and the wafer (8) to co-rotate therewith about the central axis (A) relative to said base body (11) of said base unit (10).
